# EUROPEAN PATENT APPLICATION

(11) **EP 4 722 616 A1**
(43) Date of publication of application: **08.04.2026**
(21) Application number: 25203795.7
(22) Date of filing: 22.09.2025
(51) Int. Cl.: F25B 41/24, F25B 45/00, F25B 49/00, F25B 49/02, H05K 7/20

(54) **COOLING SYSTEM AND METHOD OF CONTROLLING FLUID FLOW OF A COOLING SYSTEM**

(30) Priority: 26.09.2024 US 202463699395 P
(71) Applicant: Vertiv International GmbH, 8212 Neuhausen am Rheinfall (CH)
(72) Inventor: Takacs, Balint, 8212 Neuhausen am Rheinfall (CH); Barbato, Pierpaolo, 8212 Neuhausen am Rheinfall (CH); Perejda, Jan, 8212 Neuhausen am Rheinfall (CH)
(74) Representative: Cousens, Nico

(57) **Abstract**

A cooling system for charging and discharging fluid is disclosed. The system includes a main fluid circuit and a secondary fluid circuit. The secondary fluid circuit includes: a receiver configured to receive and discharge fluid flowing through the main fluid circuit and the secondary fluid circuit; a pump configured to communicate with the receiver; a receiving valve selectively open to direct fluid to the receiver; and a returning valve selectively open to discharge fluid from the receiver. The system further includes a controller communicating with the main fluid fircuit and the secondary fluid circuit and a sensor detecting sensing value within the cooling system.

## Description

The present disclosure claims the benefit under 35 U.S.C. 119(e) of U.S. Provisional Application No. 63/699,395, filed September 26, 2024.

### TECHNICAL FIELD

The present disclosure relates to cooling systems, more specifically, to systems and methods for adjusting refrigerant evacuation and charge.

### BACKGROUND

Data centers have ever-rising heat density, requiring thermal systems to provide increased cooling density. Additionally, recent trends toward higher-density data centers for artificial intelligence require higher heat rejection per footprint. Various cooling systems have been used to cool data centers, particularly, electronic devices (e.g., processors, memories, networking devices, chips, and other heat-generating devices) located on a server or network rack tray. For instance, forced convection may be created by providing a cooling airflow over the devices. Fans located near the devices, fans located in computer server rooms, and/or fans located in ductwork in fluid communication with the air surrounding the electronic devices, may force the cooling airflow over the tray containing the devices. A newer cooling method includes direct-to-chip liquid cooling, which can provide fluid to cool the electronics without using cooling fans. For instance, liquid may be sent to cold plates, mounted directly on heated electronic devices, to absorb the heat. This liquid is then transported to a coolant distribution unit (CDU) where a heat exchanger is used to dissipate the heat. Such cooling systems have applicability in a number of different applications where media (e.g., fluid) is to be or must be cooled. The fluid may be a gas such as air, or a liquid such as water or refrigerant.

The efficiency of cooling systems has taken on increased importance. Cooling and power conversion systems for data centers consume at least half the power used in a typical data center. In other words, less than half the power is consumed by the servers in the data center. This has led to an increased focus on energy efficiency in data center cooling systems. However, current cooling systems undergo an undesirable pressure drop throughout the system, which decreases energy efficiency. Some cooling systems include a receiver to ensure refrigerant flowing to the expansion device to help maintain a stable subcooling. However, a pressure drop is still unavoidable, which can negatively affect the capacity and efficiency of the system. In addition, there is an unnecessary loss of refrigerant when a leak occurs.

In view of the foregoing, there needs improved refrigerant leak capture and reuse systems and methods that can also reduce the risk of critical technology failure and danger, while promoting environmental regulations.

### SUMMARY

According to an exemplary embodiment of the present disclosure, a cooling system for charging and discharging fluid is disclosed. The system includes: a main fluid circuit; a secondary fluid circuit; a controller configured to communicate with the main fluid circuit and the secondary fluid circuit; and a sensor configured to detect a sensing value within the cooling system and communicate with the controller. The secondary fluid circuit includes: a receiver configured to receive and discharge fluid flowing through the main fluid circuit and the secondary fluid circuit; a pump configured to communicate with the receiver; a receiving valve selectively open to direct fluid to the receiver; and a returning valve selectively open to discharge fluid from the receiver.

In some embodiments, the receiving valve includes: a first valve configured to be selectively open and closed to allow fluid flow from the main fluid circuit to the pump through the secondary fluid circuit; and a second valve configured to be selectively open and closed to allow fluid flowing from the pump to flow to the receiver on the secondary fluid circuit. In some embodiments, the returning valve includes: a third valve configured to be selectively open and closed to allow fluid flow out from the receiver to the pump; and a fourth valve configured to be selectively open and closed to allow fluid flow from the secondary fluid circuit to the main fluid circuit.

In some embodiments, when the controller determines a fluid leak based on the sensing value, the receiving valve is open and the returning valve is closed. In some embodiments, when the controller determines no leak based on the sensing value, the receiving valve is closed and the returning valve is open. In some other embodiments, when the controller determines that an amount of fluid in the main fluid circuit is less than a target amount based on the sensing value, the receiving valve is closed and the returning valve is open.

In some embodiments, the secondary fluid circuit further includes a scale arranged below the receiver, the scale configured to measure a fluid weight inside the receiver. The main fluid circuit connects an indoor unit disposed inside a building and an outdoor unit disposed outside the building. In some embodiments, the outdoor unit includes a condenser, a condenser fan, a fluid pump, a check valve, and a solenoid valve. In some embodiments, the indoor unit includes an evaporator, an evaporator fan, a compressor, and an expansion device. The sensor includes at least one of a temperature sensor, a pressure sensor, or a humidity sensor.

In accordance with another embodiment of the present disclosure, a method of controlling fluid flow of the cooling system is disclosed. The method may include: detecting, by the sensor, the sensing value; determining, by the controller, whether there is a fluid leak based on the sensing value; upon determining there is no leak, operating the cooling system in a steady state; measuring, by the sensor, a subcooling value; determining whether the subcooling value is within a threshold (or target); upon determining the subcooling value is outside the threshold, controlling the receiving valve to open the returning valve to close to direct fluid flowing from a condenser to a receiver; waiting for a predetermined period of time; and repeating the steps.

In some embodiments, the method further includes: upon determining that there is leak in the step of determining whether there is fluid leak, controlling the receiving valve to open and the returning valve to close to direct fluid to the receiver; upon determining that the subcooling value is within the threshold, closing the receiving valve and opening the returning valve to flow fluid to the main fluid circuit from the receiver; and upon determining that the cooling system is not in the steady state, performing the method from the step of determining whether there is fluid leak.

In some embodiments, the determining whether the subcooling value is within a threshold comprises determining whether the subcooling value greater than or less than the threshold. The method may further include: upon determining that the subcooling value is greater than the threshold, closing the receiving valve and opening the returning valve; upon determining that the subcooling value is less than the threshold, opening the receiving valve and closing the returning valve; and after determining there is no leak but the cooling system is not operated in the stead state, performing the step of determining whether there is fluid leak based on the sensing value and repeating the steps.

Other aspects and advantages of the disclosure will become apparent from the following detailed description, taken in conjunction with the accompanying drawings, illustrating by way of example the principles of the disclosure.

### BRIEF DESCRIPTION OF THE DRAWINGS

The disclosure will be readily understood by the following detailed description in conjunction with the accompanying drawings, wherein like reference numerals designate like elements:
**FIG.** 1 shows an example of a typical cooling system for a data center according to a prior art.
FIG. 2 shows a typical cooling system having a Direct Expansion (DX) cooling circuit of FIG. 1 as one example.
FIG. 3 shows a typical cooling system having a DX cooling circuit with a pumped refrigerant economizer mode of FIG. 1 as another example.
FIG. 4 shows a cooling system having a DX cooling circuit according to one exemplary embodiment of the present disclosure.
FIG. 5 shows a cooling system having a DX cooling circuit with a pumped refrigerant economizer mode according to another exemplary embodiment of the present disclosure.
FIG. 6 shows a method of controlling a cooling system for evacuation and charge or refrigerant according to various embodiments of the present disclosure.
FIG. 7 shows a graph depicting a charge effect on energy consumption of a compressor using a cooling system according to various embodiments of the present disclosure.
FIG. 8 is a block diagram of an example computing device that may be used to implement embodiments, according to embodiments of the present disclosure.

### DETAILED DESCRIPTION

The figures described above and the written description of specific structures and functions below are not presented to limit the scope of what Applicants have invented or the scope of the appended claims. Rather, the Figures and written description are provided to teach any person skilled in the art to make and use the part of the disclsoure for which patent protection is sought (as defined by the claims). Those skilled in the art will appreciate that not all features of a commercial embodiment of the disclosure are described or shown for the sake of clarity and understanding. Persons of skill in this art will also appreciate that the development of an actual commercial embodiment incorporating aspects of the present disclosure will require numerous implementation-specific decisions to achieve the developer's goal for the commercial embodiment. Such implementation-specific decisions may include and likely are not limited to, compliance with system-related, business-related, government-related, and other constraints, which may vary by specific implementation, location, and from time to time. While a developer's efforts might be complex and time-consuming in an absolute sense, such efforts would be, nevertheless, a routine undertaking for those of skill in this art having the benefit of this disclosure. It must be understood that the disclosure taught herein is susceptible to numerous and various modifications and alternative forms.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the disclosure or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

Embodiments described herein relate to techniques for cooling data centers. In particular, systems and methods of the present disclosure provide new and novel refrigerant leak capture and release systems with simple reconfiguration of the existing cooling systems, resulting in a solution that is not overly complex or expensive and allows adheres to existing standards. For example, the system and method of the present disclosure may improve recovery, recycling, and/or reclamation of refrigerant fluids. Further, the system and method of the present disclosure may be configured to adjust the amount of refrigerant within a refrigerant circuit.

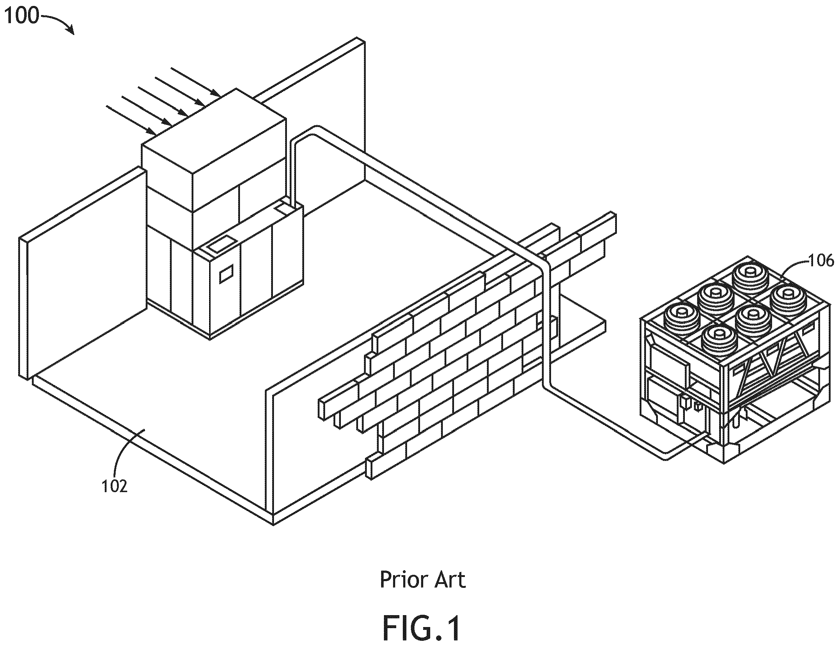

FIG. 1 shows a typical cooling system 100 for a building, e.g., a data center 102, having an indoor unit 102 and an outdoor unit 106. The indoor unit 102 may include an evaporator, a fan, a compressor, and an expansion device. The outdoor unit 106 may include a condenser coil, a fan, and a pump. The indoor unit 102 inside the building (e.g., data center 102) may fluidly communicate with the outdoor unit 106 located outside the building through a closed fluid circuit. The fluid (e.g., refrigerant) flowing within the circuit may be generally formulated to undergo phase changes within the normal operating temperatures and pressures of the system 100 so that quantities of heat can be exchanged by virtue of the latent heat of vaporization of the refrigerant. As such, the refrigerant flowing within the system 100 may travel through multiple conduits and components of the circuit.

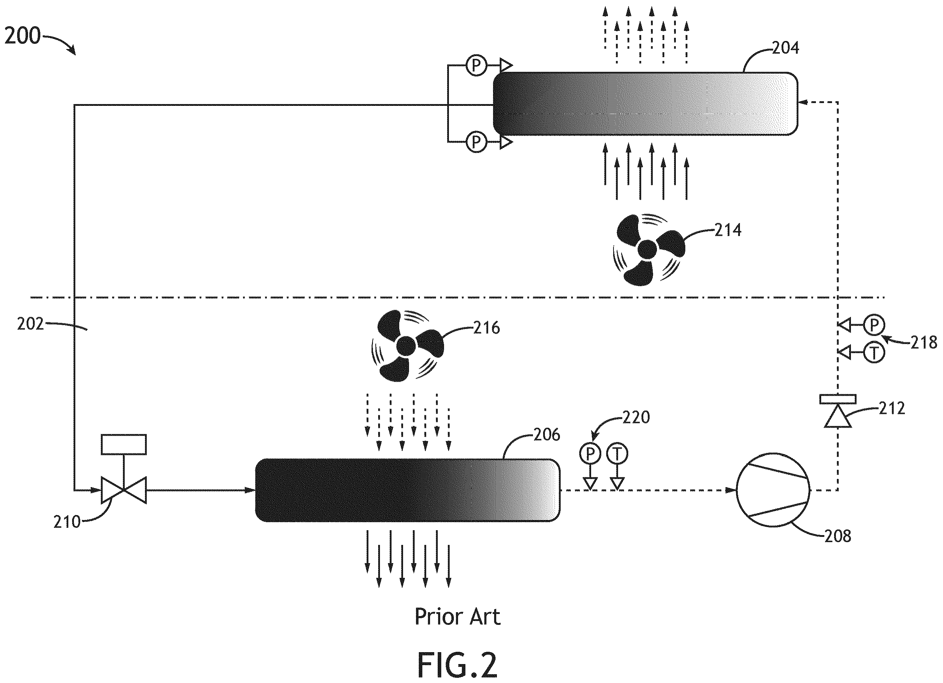

FIG. 2 shows a cooling system 200 having an indoor unit in a data center 202 and an outdoor unit outside the data center 202. The outdoor unit may include a condenser 204 with a condenser fan 214. The indoor unit may be a DX cooling system including an evaporator 206 with an evaporator fan 216, a compressor 208, an expansion device 210, a check valve 212, and one or more sensors 218, 220 (e.g., temperature and pressure sensors). Each component of the DX cooling system 200 may fluidically communicate with each other via one or more fluid lines. It is noted herein that this simple configuration may allow warm air in the data center 202 to blow into the evaporator 206 by the evaporator fan 216, become compressed by the compressor 208 to remove refrigerant vapor, and be condensed by the condenser 204 while heat is transferred from the condensing vapor to outside. Then, the expansion device 210 creates a pressure drop to create a two-phase mixture of the refrigerant.

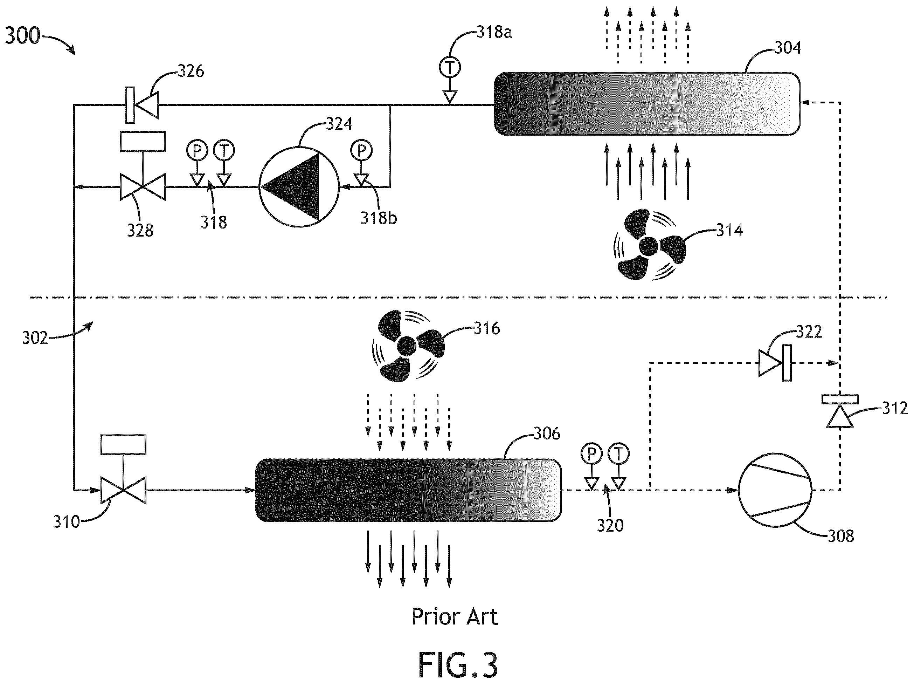

FIG. 3 shows another cooling system 300 having an indoor unit in a data center 302 and an outdoor unit outside the data center 302. The outdoor unit may include a condenser 304 with a condenser fan 314. The indoor unit may include an evaporator 306 with an evaporator fan 316, a compressor 308, an expansion device 310, a check valve 312, and one or more sensors 318a, 320 (e.g., temperature and pressure sensors). Each component of the cooling system 300 may fluidically communicate with each other via one or more fluid lines.

While the cooling system 200 is the typical DX cooling system, the cooling system 300 may include a DX cooling circuit with a pumped refrigerant economizer mode. For example, as shown in FIG. 3, the cooling system 300 may include additional components. For instance, the indoor unit may further include an additional valve 322 and the outdoor unit may further include a fluid pump 324, a check valve 326, and a solenoid valve 328. The cooling system 300 may include one or more additional sensors 318, 318b for pressure differential at the pump 324. These additional components of the outdoor unit may also be known as an EconoPhase unit or economizer system. The details of this EconoPhase unit are described in U.S. Patent No. 9,038,404.

The cooling systems 200 and 300 are configured to absorb heat (e.g., from servers) from a given space (e.g., a data center) and transfer it outside the space, e.g., to an external environment where the heat is dissipated. The techniques of the present disclosure are applicable to all cooling systems. Refrigerant is passed in a generally counterclockwise direction in one or more pipes or conduits represented using a series of consecutive arrows arranged in a ring/rectangle. However, the direction can be reversed so that refrigerant may be controlled to flow in a clockwise direction. This may be referred to as the refrigerant circuit. The refrigerant circuit is configured to circulate refrigerant to cool down the air of the air circuit. The refrigerant used in the refrigerant circuit may be water, a water-glycol mixture, fluorinated gases (F-gases) or natural gases such as carbon dioxide or propane. As would be understood by the skilled person, the refrigerant may be a mixture of gases such as R410A or R1234ze.

As noted above, the refrigerant circuit is a closed circuit in which the same refrigerant circulates while changing its physical properties, such as pressure, temperature, and state, e.g., liquid or gas. However, in the current cooling circuits such as the cooling systems 200 or 300, undesirable amounts of refrigerant may leak and escape into the atmosphere. A refrigerant leak is undesirable for several reasons. For example, refrigerant is expensive and a cooling system requires a certain amount of refrigerant to operate correctly, such that it is advantageous to avoid the need to replace lost refrigerant. In addition, loss of refrigerant may have a negative impact on components of a cooling system such as the compressor, such that it may lead to a need for replacing or repairing such components. Moreover, use of a lower amount of refrigerant increases the energy efficiency ratio (EER) of a cooling system. For substantial leaks, the cooling system will lose its capability to function properly and would not be able to provide the cooling for which it was designed, which could introduce unwanted downtime in the data center. A service call to repair/refill the cooling system would lead to additional downtime. In addition, lost refrigerants have a non-zero global warming potential (GWP), such that undetected leaks introduce more greenhouse gases into the atmosphere and degrade the sustainability of a data center. Furthermore, refrigerants may be flammable such that a leak to atmosphere may also lead to safety issues. Moreover, refrigerants are toxic or denser than air so the oxygen could be pushed out by leaked refrigerants, which could lead to suffocation.

It is thus necessary to properly and efficiently detect a refrigerant leak before the operation of a cooling system is degraded significantly leading to unwanted downtime. It would also be desirable to more reliably determine which cooling system is leaking in order to further increase the speed of detecting the specific location of the leak and to avoid the need to turn off multiple cooling systems to examine each of them. Further, it is beneficial to capture the leak without negatively affecting the operation of cooled components and efficiently reuse as needed, thus no loss of leak in the cooling system. If a leak is detected, whether directly or indirectly, it is possible to evacuate/direct the refrigerant charge into the tank, which would reduce the amount of leaked refrigerant and could be reused when needed. As previously described, the present disclosure makes it possible to enhance safety by limiting the amount of refrigerant in an enclosed space.

The systems and methods of the present disclosure focus on techniques for capturing a leak in a cooling system before the operation of a cooling system is degraded, to reduce unwanted downtime. Further, systems and methods of the present disclosure provide techniques for restoring refrigerant to be reused, promoting a green data center and energy efficiency operations.

In accordance with an aspect of the present disclosure, a high efficiency cooling system may include staged cooling provided by two or more cooling circuits arranged so that air to be cooled flows through them serially. In an aspect, each cooling circuit may include a tandem digital scroll compressor made up of a fixed capacity scroll compressor and digital scroll compressor. It should be understood that instead of tandem digital compressors, a plurality of compressors can be plumbed in parallel and these compressors may have differing capacities. In an aspect, each cooling circuit may be a DX cooling circuit only or a DX cooling circuit and a pumped refrigerant economization circuit that bypasses the compressor when the outdoor temperature is sufficiently low to provide the requisite cooling to the refrigerant being circulated in the cooling circuit. In an aspect, the high efficiency cooling system may further include one or more fans, blowers or similar air moving units that move air to be cooled through the evaporators of each cooling circuit. The motors of the air moving unit may illustratively be variable speed motors, and may illustratively be electronically controlled motors. The same may be the case for the fan motors for the condenser. In an aspect, the cooling circuits of the high efficiency cooling system may include an electronic expansion valve.

It should be understood that a cooling system can have less than all these elements, and can have various combinations of them. For example, the cooling system may not have staged cooling but have a cooling circuit that includes a DX cooling circuit only or a DX cooling circuit and the pumped refrigerant economization circuit. In this aspect, the tandem digital scroll may or may not be utilized.

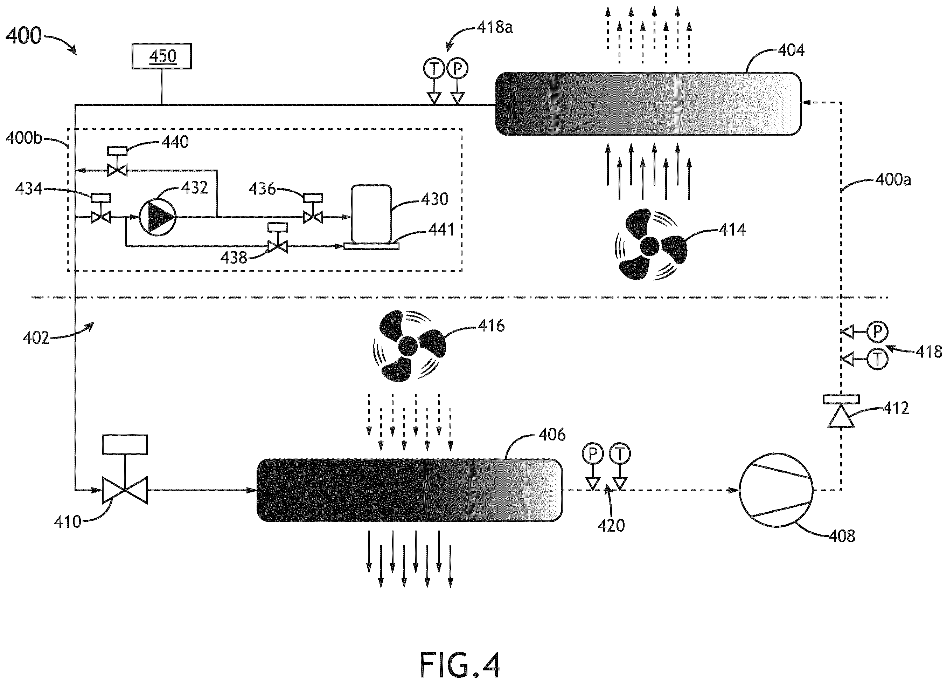

FIG. 4 shows a cooling system 400 having a Direct Expansion (DX) cooling circuit according to one exemplary embodiment of the present disclosure.

The cooling system 400 (which may also be referred to as a cooling delivery unit) may be configured to absorb heat from a given space (for example as generated by servers) and transfer it outside of the space, for example to an outside environment where the heat is released. The techniques of the present disclosure are applicable to all cooling systems. The cooling system 400 of FIG. 4 may be an air handling unit (AHU) with one circuit, for ease of explanation, though the techniques of the present disclosure are not limited thereto.

In embodiments, the cooling system 400 may be divided into two parts including an air circuit and a fluid circuit, respectively. The air circuit may be configured to move hot air by sucking the hot air from the servers into the cooling system 400 and supplying the same air with a lower temperature back to the servers. This may be performed using fans. The air is represented in FIG. 4 using the series of adjacent, vertical arrows pointing upwards and downwards from the evaporator 406 and condenser 404. Here, fluid (e.g., refrigerant) is passed in one or more pipes or conduits (e.g., fluid circuit). The fluid circuit is configured to circulate fluid to cool down the air of the air circuit, similar to the cooling system 200.

In some embodiments, the cooling system 400 includes, on a main fluid circuit 400a, at least two heat exchanger configurations. For example, the cooling system 400 may include an evaporator 406 disposed inside a building 402 (e.g., data cener) and a condenser 404 located outside the building. For instance, the indoor unit 402 may include the evaporator 406 with an evaporator fan 416 configured to move hot air from one or more servers and their surroundings to the evaporator 406 (also known as an evaporator coil, coil, heat exchanger, etc.). In this regard, the hot air may pass across the evaporator 406 and be cooled down as the fluid absorbs the heat. This occurs without mixing of the air and the fluid. The cooler air can then be recirculated to the one or more servers to absorb further heat. Additionally, the indoor unit may include a check valve 412 for preventing backflow, maintaining pressure, and protecting the cooling system 400 to ensure safety and efficiency.

During the heat absorption, the state of the fluid changes from liquid to gas. Subsequently, this fluid gas may be sucked into a compressor 408. The compressor 408 may be configured to increase the pressure of the fluid and transfer it to the condenser 404 (also known as a condenser coil, coil, heat exchanger, etc.). A condenser fan 414 may be configured to circulate cool air across the condenser 404 in order to cool down the fluid until it condensates (e.g., changes state from gas to liquid). The liquid fluid is then fed back towards the evaporator 406. The fluid may also pass through an expansion device 410 (or expansion valve) configured to control the amount of fluid that flows back into the evaporator 406.

In some embodiments, the cooling system 400 further includes additional components between the condenser 404 and the expansion device 410 and connected via fluid lines. For example, the cooling system 400 may include a receiver or tank 430 configured to act as a fluid buffer, i.e. a storage tank for the fluid. This configuration can provide flexibility in the amount of fluid supplied through providing a means for holding excess fluid. The amount of fluid needed is dependent on the predicted working condition of the cooling system 400 including the suction and the condensing pressure. The quantity of fluid needed is also dependent on the value of subcooling. For example, if the cooling system 400 includes a smaller amount of fluid, lower subcooling will result. It is contemplated herein that the cooling system 400 should include enough fluid such that it can deliver the cooling capacity requested, howver it is undesirable to include too much fluid due to its high cost.

The cooling system 400 may further include a pump 432 connected prior to the receiver 430, and electrically controlled or actuated valves 434, 436, 438, and 440, such as solenoid on/off valves or motor-driven on/off valves. In case of leak detection, a corresponding valve among the several solenoid valves 434, 436, 438, and 440 on the fluid line may be selectively opened and the pump 432 can start to ramp up to migrate the fluid from the fluid line into the receiver 430. Here, leak detection methods are described in EP Appl. No. 24166513.2, U.S. Non-Provisional Appl. No. 19/068,928, U.S. Provisional Appl. No. 63/634,699, PCT Application Number PCT/US25/24693, U.S. Provisional Appl. No. 63/657,682, and U.S. Application No. 19/231,361 and thus, details thereof are omitted herein. However, various fluid or refrigerant leak detection can be adopted in the present systems and methods.

In some embodiments, based on leak detection, the valves 434, 436, 438, and 440 may be selectively opened or closed. More specifically, the cooling system 400 can be controlled at the given amount of fluid in the circuit. For instance, the cooling system 400 may include various sensors 418, 418a, and 420 to determine the fluid leak within the cooling system 400 or fluid circuit. The various sensors may be temperature sensors, pressure sensors, humidity sensors, or a combination thereof, which can measure the actual subcooling of the circuit. When there are 4 solenoid valves 434, 436, 438, and 440 within a circuit or a secondary fluid circuit 400b, the first and second valves 434 and 436 as a pair (or receiving valve) may be controlled to be closed or open while the third and fourth valves 438 and 440 as another pair (as returning valve) may be controlled to be open or closed, respectively. The valves within each pair may be controlled together, that is, when the first valve 434 is open (or closed), the second valve 436 is open (or closed), and vice versa. The number of valves is however not limited to 4 but could be more than or less than 4 based on the refrigerant circuit and/or entire cooling system configuration.

More specifically, in case of leak detection in the cooling system 400, particularly after fluid passes through the condenser 404 before entering the expansion device 410, the first and second valves 434 and 436 may be controlled to be open as removing valves, and the third and fourth valves 438 and 440 are closed as charging valves. When the first valve 434 is open, fluid can flow to an inlet of pump 432 to prevent fluid from being wasted to the atmosphere. The fluid can then flow to an inlet of a solenoid valve or second valve 436 which can be controlled to be open to allow fluid to flow to the receiver 430 while the third and fourth valves 438 and 440 are closed.

This allows for capturing the fluid or forcing the cooling system 400 to vacuum (or discharging), which has several benefits. For example, the benefits include, but are not limited to: 1) an economic value by saving the fluid loss, 2) environmental value by lowering the amount of refrigerant introduced into the atmosphere, and 3) a safety value by ensuring no more refrigerant would be introduced into the closed space (e.g., a catastrophic scenario in case of upland ignition) in case of flammable refrigerant

On the other hand, in the case of fluid charging, that is, returning to the main fluid line, the first and second valves 434 and 436 are closed while the third and fourth valves 438 and 440 are open. Here, the third valve 438 may be open to allow stored fluid to flow from the receiver 430 back to the pump 432 (by opening the third valve 438) and then either back to the main fluid line (by opening the fourth valve 440 and closing the second valve 436) or back to the receiver 430 (by opening the second valve 436 and closing the fourth valve 440).

The opening of third and fourth valves 438 and 440 may be determined and controlled when no more leak is determined within the system 400 or servicing has been completed to fix the leak. Additionally or alternatively, when the refrigerant line needs additional fluid for cooling purpose, the third and fourth valves 438 and 440 can be controlled to be open to release some of the fluid from the receiver 430.

The above-described control systems allow dynamic charge adjustment based on the cooling system operation conditions (charge, ambient, cooling capacity, etc.). There are several benefits by automatically adjusting the fluid/refrigerant charge, that is adjusting the amount of fluid back to the cooling circuit in the optimal energy efficiency. When there are more than or less than needed, refrigerant could have negative impact on energy efficiency. With the above-described configurations of the present disclosure, it is possible to dynamically and automatically modify the charge for better energy efficiency.

In some embodiments, subcooling of the system 400 may be continuously measured, and thus, a charge of the circuit can be automatically controlled accordingly. With a lower charge, the subcooling would decrease, increasing with a higher charge. A low amount of fluid has a negative effect on the unit's deliverable cooling capacity, which could be detected, for example, by the solenoid valve positions. In case in which there is more fluid in the circuit than it is needed, the active heat exchanging surface would be lower on the condenser, which in extreme cases could decrease the capacity of the condenser dramatically. The correct amount of fluid is also a function of the operation environment. The ideal fluid charge is different in the case of hot and cold ambient ( summer vs winter). The presented mechanism would allow to continuous monitoring of the circuit and adjust the fluid charge accordingly to ensure the correct cooling system operation.

Furthermore, to quantify the amount of fluid in the circuit, the cooling system 400 may further include a scale 441, which signal would be connected to the local controller. The scale reading would serve as a control mechanism to evaluate the correct fluid charge. For example, when the scale 441 shows that the tank 430 is empty, and the cooling system 400 is in working in conditions, which would require lower amount fluid that could be an indication of possible leak on the system.

The valve opening and closing controls as described above can ensure limiting the amount of fluid introduced or no refrigerant leak into the atmosphere. This would reduce fluid or refrigerant recharge when there is refrigerant loss to the atmosphere. Furthermore, in the case of flammable gasses, a migration of all the fluid from the server rooms might be necessary due to safety reasons. The fluid migration routine could be directly implemented on the local controller and in case of a service event the service technician could activate routine, which would allow safe and proper inspection of the cooling system. Furthermore, this tank could serve as a charge delivery mechanism, which could hold the whole charge for the given circuit (plus a predefined amount of extra fluid if needed). After unit installation when the circuit passed the sealing tests, the circuit could be charged from the introduced tank.

The control of the above-described valves based on detected data can be performed by a controller 450 communicating with various electronic devices within the cooling system 400. The valve opening and closing controls as described above can ensure limiting the amount of fluid introduced or no refrigerant leak into the atmosphere. This would reduce fluid or refrigerant recharge when there is refrigerant loss to the atmosphere. Furthermore, in the case of flammable gasses, a migration of all the fluid from the server rooms might be necessary due to safety reasons. The fluid migration routine could be directly implemented on the local controller and in case of a service event the service technician could activate routine, which would allow safe and proper inspection of the cooling system. Furthermore, this tank could serve as a charge delivery mechanism, which could hold the whole charge for the given circuit (plus a predefined amount of extra fluid if needed). After unit installation when the circuit passed the sealing tests, the circuit could be charged from the introduced tank.

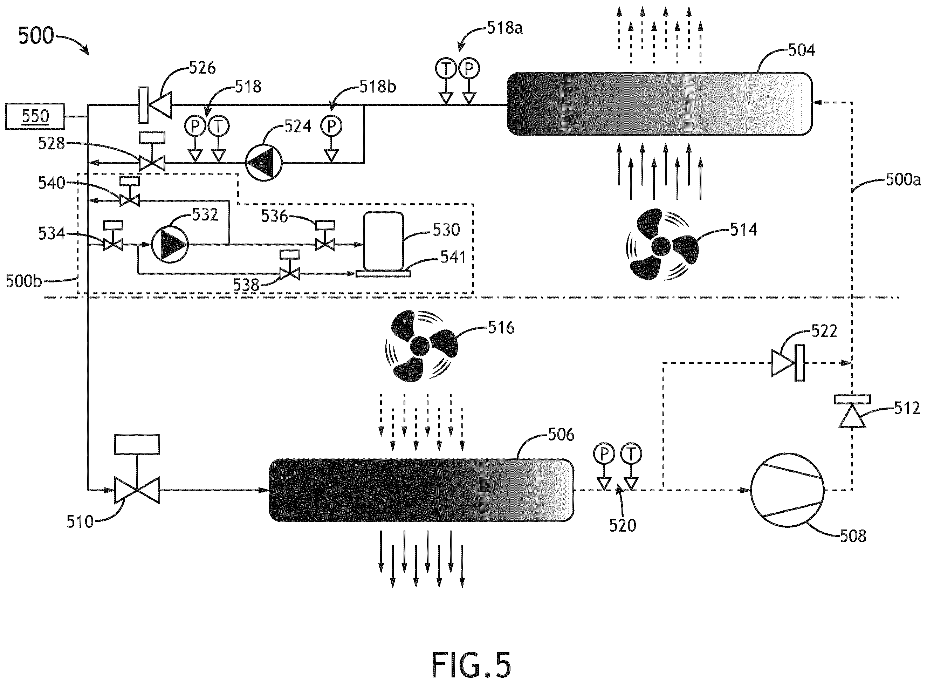

FIG. 5 shows a cooling system 500 having a DX cooling circuit with a pumped fluid economizer mode according to another exemplary embodiment of the present disclosure.

The cooling system 500 includes a circuit 500b that includes similar features to the circuit 400b of the cooling system 400 of FIG. 4. Each valve in the circuit 500b can be controlled in a similar manner, e.g., first and second valves 534 and 536 can be open or closed as a pair, while third and fourth valves 538 and 540 can be closed or open as another pair.

In embodiments, the cooling system 500 may be divided into two parts including an air circuit and a fluid circuit, respectively. The air circuit may be configured to move hot air by sucking the hot air from the servers into the cooling system 500 and supplying the same air with a lower temperature back to the servers. This may be performed using fans. The air is represented in FIG. 5 using the series of adjacent, vertical arrows pointing upwards and downwards from the evaporator 506 and condenser 504. Here, fluid (e.g., refrigerant) is passed in one or more pipes or conduits (e.g., fluid circuit). The fluid circuit is configured to circulate fluid to cool down the air of the air circuit, similar to the cooling system 200.

In some embodiments, the cooling system 500 includes, on a main fluid circuit 500a, at least two heat exchanger configurations. For example, the cooling system 500 may include an evaporator 506 located inside a building (e.g., data cener) and a condenser 504 located outside the building. For instance, the indoor unit may include the evaporator 506 with an evaporator fan 516 configured to move hot air from one or more servers and their surroundings to the evaporator 506 (also known as an evaporator coil, coil, heat exchanger, etc.). In this regard, the hot air may pass across the evaporator 506 and be cooled down as the fluid absorbs the heat. This occurs without mixing of the air and the fluid. The cooler air can then be recirculated to the one or more servers to absorb further heat. Additionally, the indoor unit may include a check valve 512 for preventing backflow, maintaining pressure, and protecting the cooling system 500 to ensure safety and efficiency.

During the heat absorption, the state of the fluid changes from liquid to gas. Subsequently, this fluid gas may be sucked into a compressor 508. The compressor 508 may be configured to increase the pressure of the fluid and transfer it to the condenser 504 (also known as a condenser coil, coil, heat exchanger, etc.). A condenser fan 514 may be configured to circulate cool air across the condenser 504 in order to cool down the fluid until it condensates (e.g., changes state from gas to liquid). The liquid fluid is then fed back towards the evaporator 506. The fluid may also pass through an expansion device 510 (or expansion valve) configured to control the amount of fluid that flows back into the evaporator 506.

In some embodiments, the cooling system 500 further includes additional components between the condenser 504 and the expansion device 510 and connected via fluid lines. For example, the cooling system 500 may include a receiver or tank 530 configured to act as a fluid buffer, i.e. a storage tank for the fluid. This configuration can provide flexibility in the amount of fluid supplied through providing a means for holding excess fluid. The amount of fluid needed is dependent on the predicted working condition of the cooling system 500 including the suction and the condensing pressure. The quantity of fluid needed is also dependent on the value of subcooling. For example, if the cooling system 500 includes a smaller amount of fluid, lower subcooling will result. It is contemplated herein that the cooling system 500 should include enough fluid such that it can deliver the cooling capacity requested, howver it is undesirable to include too much fluid due to its high cost.

The cooling system 500 may further include a pump 532 connected prior to the receiver 530, and electrically controlled or actuated valves 534, 536, 538, and 540, such as solenoid on/off valves or motor-driven on/off valves. In case of leak detection, a corresponding valve among the several solenoid valves 534, 536, 538, and 540 on the fluid line may be selectively opened and the pump 532 can start to ramp up to migrate the fluid from the fluid line into the receiver 530.

In some embodiments, based on leak detection, the valves 534, 536, 538, and 540 may be selectively opened or closed. More specifically, the cooling system 500 can be controlled at the given amount of fluid in the circuit. For instance, the cooling system 500 may include various sensors 518, 518a, and 520 to determine the fluid leak within the cooling system 500 or fluid circuit. The various sensors may be temperature sensors, pressure sensors, humidity sensors, or a combination thereof, which can measure the actual subcooling of the circuit. When there are 4 solenoid valves 534, 536, 538, and 540 within a circuit or a secondary fluid circuit 500b, the first and second valves 534 and 536 as a pair (or receiving valve) may be controlled to be closed or open while the third and fourth valves 538 and 540 as another pair (as returning valve) may be controlled to be open or closed, respectively. The valves within each pair may be controlled together, that is, when the first valve 534 is open (or closed), the second valve 536 is open (or closed), and vice versa. The number of valves is however not limited to 4 but could be more than or less than 4 based on the refrigerant circuit and/or entire cooling system configuration.

More specifically, in case of leak detection in the cooling system 500, particularly after fluid passes through the condenser 504 before entering the expansion device 510, the first and second valves 534 and 536 may be controlled to be open as removing valves, and the third and fourth valves 538 and 540 are closed as charging valves. When the first valve 534 is open, fluid can flow to an inlet of pump 532 to prevent fluid from being wasted to the atmosphere. The fluid can then flow to an inlet of a solenoid valve or second valve 436 which can be controlled to be open to allow fluid to flow to the receiver 530 while the third and fourth valves 538 and 540 are closed.

On the other hand, in the case of fluid charging, that is, returning to the main fluid line, the first and second valves 534 and 536 are closed while the third and fourth valves 538 and 540 are open. Here, the third valve 538 may be open to allow stored fluid to flow from the receiver 530 back to the pump 532 (by opening the third valve 538) and then either back to the main fluid line (by opening the fourth valve 540 and closing the second valve 536) or back to the receiver 530 (by opening the second valve 536 and closing the fourth valve 540).

The opening of third and fourth valves 538 and 540 may be determined and controlled when no more leak is determined within the system 500 or servicing has been completed to fix the leak. Additionally or alternatively, when the refrigerant line needs additional fluid for cooling purpose, the third and fourth valves 538 and 540 can be controlled to be open to release some of the fluid from the receiver 530.

Furthermore, to quantify the amount of fluid in the circuit, the cooling system 500 may further include a scale 541, which signal would be connected to the local controller. The scale reading would serve as a control mechanism to evaluate the correct fluid charge. For example, when the scale 541 shows that the tank 530 is empty, and the cooling system 500 is in working in conditions, which would require lower amount fluid that could be an indication of possible leak on the system.

The valve opening and closing controls as described above can ensure limiting the amount of fluid introduced or no refrigerant leak into the atmosphere. This would reduce fluid or refrigerant recharge when there is refrigerant loss to the atmosphere. Furthermore, in the case of flammable gasses, a migration of all the fluid from the server rooms might be necessary due to safety reasons. The fluid migration routine could be directly implemented on the local controller and in case of a service event the service technician could activate routine, which would allow safe and proper inspection of the cooling system. Furthermore, this tank could serve as a charge delivery mechanism, which could hold the whole charge for the given circuit (plus a predefined amount of extra fluid if needed). After unit installation when the circuit passed the sealing tests, the circuit could be charged from the introduced tank.

The control of the above-described valves based on detected data can be performed by a controller 550 communicating with various electronic devices within the cooling system 500. The valve opening and closing controls as described above can ensure limiting the amount of fluid introduced or no refrigerant leak into the atmosphere. This would reduce fluid or refrigerant recharge when there is refrigerant loss to the atmosphere. Furthermore, in the case of flammable gasses, a migration of all the fluid from the server rooms might be necessary due to safety reasons. The fluid migration routine could be directly implemented on the local controller and in case of a service event the service technician could activate routine, which would allow safe and proper inspection of the cooling system. Furthermore, this tank could serve as a charge delivery mechanism, which could hold the whole charge for the given circuit (plus a predefined amount of extra fluid if needed). After unit installation when the circuit passed the sealing tests, the circuit could be charged from the introduced tank.

While the cooling system 400 is the typical DX cooling system, the cooling system 500 may include a DX cooling circuit with a pumped refrigerant economizer mode. For example, as shown in FIG. 5, the cooling system 500 may include additional components. For instance, the indoor unit may further include an additional valve 522 and the outdoor unit may further include a fluid pump 524, a check valve 526, and a solenoid valve 528. The cooling system 500 may include one or more additional sensors 518, 518b for pressure differential at the pump 524. These additional components of the outdoor unit may also be known as an EconoPhase unit or economizer system. The details of this EconoPhase unit are described in U.S. Patent No. 9,038,404.

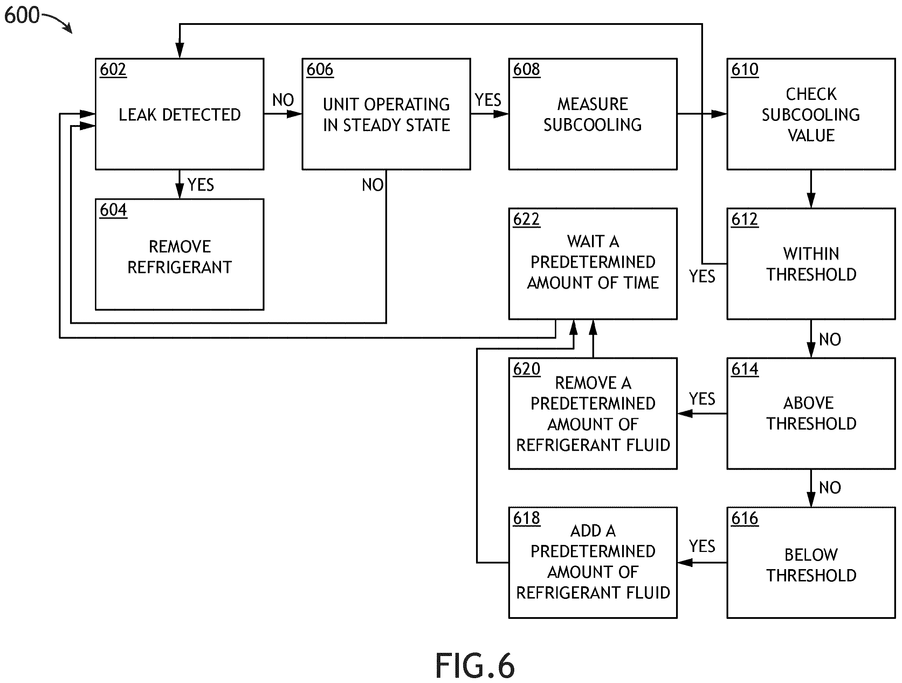

FIG. 6 shows a method 600 of controlling a cooling system for evacuation and charge or refrigerant according to various embodiments of the present disclosure.

The method 600 begins the operation by detecting leak in a step 602. If a leak is detected, the removal process is performed in a step 604. The removal process includes, as described above, selectively opening and closing corresponding valves to flow fluid to the receiver tank to avoid waste of fluid to the atmosphere. When there is no leak detected, the method 600 continues to a step 606 assuming that the cooling system 400 or 500 is operating in a steady state. The step 606 further includes confirming whether the cooling system 400 or 500 is indeed operating in the steady state. If yes in the step 606, subcooling of the cooling system 400 or 500 may be measured in a step 608. On the other hand, if no in the step 606, the method 600 repeats the process from step 602.

After measuring the subcooling in the step 608, the method 600 performs checking a subcooling value in a step 610 to be compared with a threshold (or target) in a step 612. If the subcooling value is within the threshold, the method 600 performs the step 602 and repeats the operation. On the other hand, if the subcooling value is outside the threshold (e.g., greater than or above the threshold), the method 600 performs a step 614 to determine whether the measured subcooling value is above (or greater than) the threshold. If the subcooling value is outside the threshold but not above the threshold, the method 600 checks whether the subcooling value is less than the threshold in a step 616. In step 614, on the other hand, if it is determined that the subcooling value is above the threshold (or greater than the threshold), the method 600 performs a step 620 of removing a predetermined amount (for example, 100-250 grams) of fluid (or refrigerant). The predetermined amount may be set and vary based on the cooling system, size, need for cooling temperature, or the like. After removing the fluid in the step 620, the method 600 waits for a predetermined period of time (e.g., 5-15 minutes) in a step 622, before repeating the operation of the method 600.

In some embodiments, when it is determined that the subcooling value is below the threshold in the step 616, the method 600 performs a step 618 of adding a predetermined amount (for example, 100-250 grams) of fluid (or refrigerant) and then performs the step 622 waiting for the predetermined period of time before repeating the operation of the method 600.

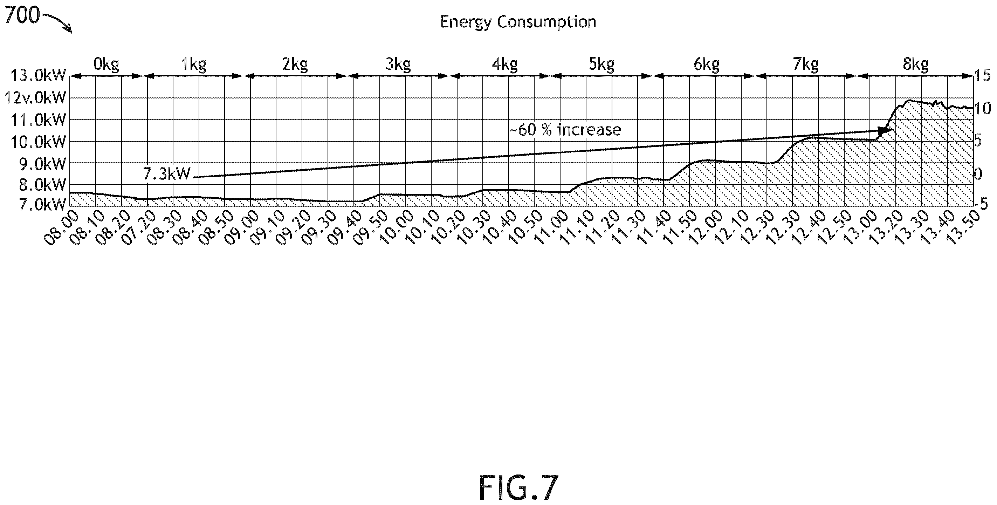

FIG. 7 shows a graph 700 depicting a charge effect on the energy consumption of a compressor using a cooling system 400, 500 according to various embodiments of the present disclosure. In particular, the graph 700 of FIG. 7 depcits laboratory results showing the effect of the charge on the energy consumption of the compressor. Even with stable conditions just by changing the charge (e.g., removing a given amount of fluid from the circuit) energy consumption of the compressor could increase more drastically, we have experienced more than a 60% increase. On the other hand, overcharging the unit would have an effect on the energy consumption of the condenser fans, the more unnecessary charge is introduced to the cooling the higher the energy consumption of the condenser fans would be.

The systems and methods according to the present disclosure could be used as a dual-purpose solution. The fluid evacuation is a safety feature with a financial bonus (saving refrigerant from leaking into the atmosphere). Once the signal is sent, the charge is evacuated into the tank. Another aspect of the present disclosure is to save energy by ensuring correct operating charge. The required optimal operation charge is a function of many variables like cooling capacity, ambient air temperature, subcooling, operation mode (compressor, pump refrigerant economizer, mixed), etc. By adjusting the charge, it is possible to achieve improved energy efficiency, while maintaining controllability and desired cooling capacity.

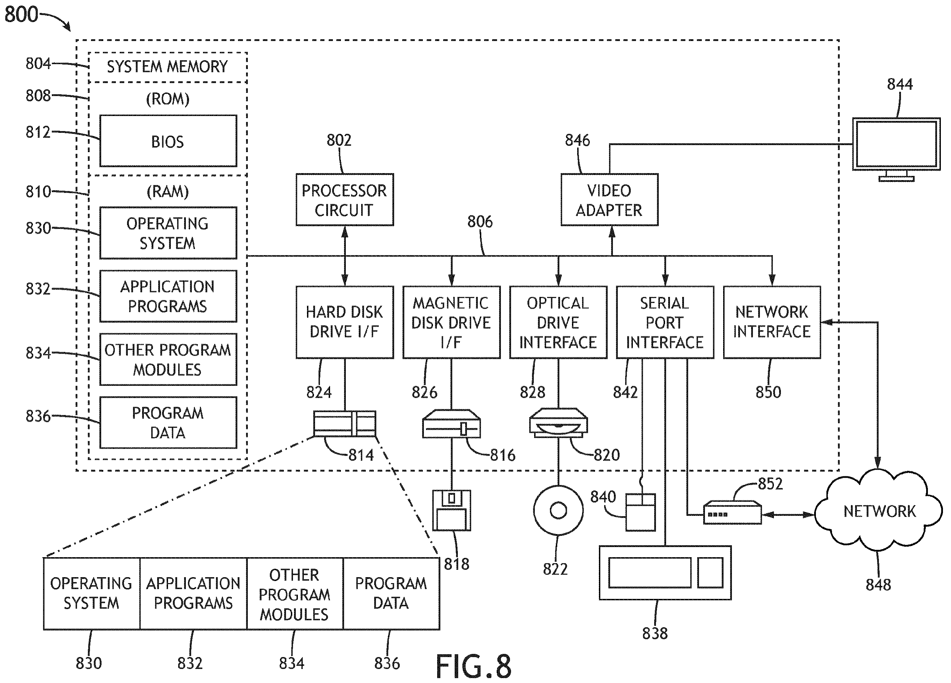

FIG. 8 depicts an example processor-based computer system 800 that may be used to implement various embodiments described herein, such as any of the embodiments described above and in reference to FIGS. 4 and 5. For example, the processor-based computer system 800 may be used to implement any of the components of the cooling systems 400 and 500 as described above in reference to FIGS. 4 and 5. The description of processor-based computer system 800 provided herein is provided for purposes of illustration and is not intended to be limiting. Embodiments may be implemented in further types of computer systems, as would be known to persons skilled in the relevant art(s).

As shown in FIG. 8, the processor-based computer system 800 includes one or more processors, referred to as a processor circuit 802, a system memory 804, and a bus 806 that couples various system components including the system memory 804 to the processor circuit 802. The processor circuit 802 may include an electrical and/or optical circuit implemented in one or more physical hardware electrical circuit device elements and/or integrated circuit devices (semiconductor material chips or dies) as a central processing unit (CPU), a microcontroller, a microprocessor, and/or other physical hardware processor circuit. The processor circuit 802 may execute program code stored in a computer-readable medium, such as program code of an operating system 830, application programs 832, other programs modules 834, etc. The bus 806 represents one or more of any of several types of bus structures, including a memory bus or memory controller, a peripheral bus, an accelerated graphics port, and a processor or local bus using any of a variety of bus architectures. The system memory 804 includes read-only memory (ROM) 808 and random access memory (RAM) 810. A basic input/output system 812 (BIOS) is stored in the ROM 808. The operating system 830, the application programs 832, the other programs modules 834, and program data 836 may be stored in the RAM 810.

The processor-based computer system 800 also has one or more of the following drives: a hard disk drive 814 for reading from and writing to a hard disk, a magnetic disk drive 816 for reading from or writing to a removable magnetic disk 818, and an optical disk drive 820 for reading from or writing to a removable optical disk 822 such as a CD-ROM, DVD ROM, or other optical media. The hard disk drive 814, magnetic disk drive 816, and optical disk drive 820 are connected to the bus 806 by a hard disk drive interface 824, a magnetic disk drive interface 826, and an optical drive interface 828, respectively. The drives and their associated computer-readable media provide nonvolatile storage of computer-readable instructions, data structures, program modules, and other data for the computer. Although a hard disk, a removable magnetic disk, and a removable optical disk are described, other types of hardware-based computer-readable storage media can be used to store data, such as flash memory cards, digital video disks, RAMs, ROMs, and other hardware storage media.

A number of program modules may be stored on the hard disk, magnetic disk, optical disk, ROM, or RAM. These programs include operating system 830, one or more application programs 832, other programs 834, and program data 836. The application programs 832 or other programs 834 may include, for example, computer program logic (e.g., computer program code or instructions) for implementing the systems described above, including the embodiments described in reference to FIGS. 4-8.

A user may enter commands and information into processor-based computer system 800 through input devices such as keyboard 838 and pointing device 840 (or mouse). Other input devices (not shown) may include a microphone, joystick, game pad, satellite dish, scanner, a touch screen and/or touch pad, a voice recognition system to receive voice input, a gesture recognition system to receive gesture input or the like. These and other input devices are often connected to processor circuit 802 through a serial port interface 842 that is coupled to bus 806 but may be connected by other interfaces, such as a parallel port, game port, or a universal serial bus (USB).

A display screen 844 is also connected to bus 806 via an interface, such as a video adapter 846. The display screen 844 may be external to, or incorporated in processor-based computer system 800. The display screen 844 may display information, as well as being a user interface for receiving user commands and/or other information (e.g., by touch, finger gestures, virtual keyboard, etc.). In addition to the display screen 844, the processor-based computer system 800 may include other peripheral output devices (not shown) such as speakers and printers.

The processor-based computer system 800 may be connected to a network 848 (e.g., the Internet) through an adaptor or network interface 850, a modem 852, or other means for establishing communications over the network. The modem 852, which may be internal or external, may be connected to the bus 806 via serial port interface 842, as shown in FIG.8, or may be connected to the bus 806 using another interface type, including a parallel interface.

Embodiments are also directed to computer program products comprising computer code or instructions stored on any computer-readable medium. Such computer program products include hard disk drives, optical disk drives, memory device packages, portable memory sticks, memory cards, and other types of physical storage hardware.

As used herein, the terms "computer program medium," "computer-readable medium," and "computer-readable storage medium" are used to generally refer to physical hardware media such as the hard disk associated with hard disk drive 814, removable magnetic disk 818, removable optical disk 822, other physical hardware media such as RAMs, ROMs, flash memory cards, digital video disks, zip disks, MEMs, nanotechnology-based storage devices, and further types of physical/tangible hardware storage media (including system memory 804 of FIG. 8). Such computer-readable storage media are distinguished from and non-overlapping with communication media (do not include communication media). Communication media typically embodies computer-readable instructions, data structures, program modules, or other data in a modulated data signal such as a carrier wave. The term "modulated data signal" means a signal that has one or more of its characteristics set or changed in such a manner as to encode information in the signal. By way of example, and not limited, communication media includes wireless media such as acoustic, RF, infrared, and other wireless media, as well as wired media. Embodiments are also directed to such communication media.

As noted above, computer programs and modules (including application programs 832 and other programs 834) may be stored on the hard disk, magnetic disk, optical disk, ROM, RAM, or other hardware storage medium. Such computer programs may also be received via network interface 850, serial port interface 842, or any other interface type. Such computer programs, when executed or loaded by an application, enable processor-based computer system 800 to implement features of embodiments discussed herein. Accordingly, such computer programs represent controllers of processor-based computer system 800.

In this application, including the definitions below, the term "module" or the term "controller" may be replaced with the term "circuit." The term "module" refers to or includes an Application Specific Integrated Circuit (ASIC); a digital, analog, or mixed analog/digital discrete circuit; a digital, analog, or mixed analog/digital integrated circuit; a combinational logic circuit; a field programmable gate array (FPGA); a processor circuit (shared, dedicated, or group) that executes code; a memory circuit (shared, dedicated, or group) that stores code executed by the processor circuit; other suitable hardware components that provide the described functionality; or a combination of some or all of the above, such as in a system-on-chip.

The module may include one or more interface circuits. In some examples, the interface circuits may include wired or wireless interfaces that are connected to a local area network (LAN), the Internet, a wide area network (WAN), or combinations thereof. The functionality of any given module of the present disclosure may be distributed among multiple modules that are connected via interface circuits. For example, multiple modules may allow load balancing. In a further example, a server (also known as remote, or cloud) module may accomplish some functionality on behalf of a client module.

The term code, as used above, may include software, firmware, and/or microcode, and may refer to programs, routines, functions, classes, data structures, and/or objects. The term shared processor circuit encompasses a single processor circuit that executes some or all code from multiple modules. The term group processor circuit encompasses a processor circuit that, in combination with additional processor circuits, executes some or all code from one or more modules. References to multiple processor circuits encompass multiple processor circuits on discrete dies, multiple processor circuits on a single die, multiple cores of a single processor circuit, multiple threads of a single processor circuit, or a combination of the above. The term shared memory circuit encompasses a single memory circuit that stores some or all code from multiple modules. The term group memory circuit encompasses a memory circuit that, in combination with additional memories, stores some or all code from one or more modules.

The term memory circuit is a subset of the term computer-readable medium. The term computer-readable medium, as used herein, does not encompass transitory electrical or electromagnetic signals propagating through a medium (such as on a carrier wave); the term computer-readable medium may therefore be considered tangible and non-transitory. Non-limiting examples of a non-transitory, tangible computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

Although the terms first, second, third, etc. may be used herein to describe various elements, pumps, condenser fans, compressors, circuits, components and/or modules, these items should not be limited by these terms. These terms may be only used to distinguish one item from another item. Terms such as "first," "second," and other numerical terms when used herein do not imply a sequence or order unless clearly indicated by the context. Thus, a first item discussed herein could be termed a second item without departing from the teachings of the example implementations.

Process flowcharts discussed herein illustrate the operation of possible implementations of systems, methods, and computer program products according to various embodiments of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A cooling system (400) for charging and discharging fluid, the cooling system comprising:
a main fluid circuit (400a);
a secondary fluid circuit (400b) comprising:
a receiver (430) configured to receive and discharge fluid flowing through the main fluid circuit and the secondary fluid circuit;
a pump (432) configured to communicate with the receiver;
a receiving valve (436) selectively open to direct fluid to the receiver; and
a returning valve (438) selectively open to discharge fluid from the receiver;
a controller (450) configured to communicate with the main fluid circuit and the secondary fluid circuit; and
a sensor (418, 420) configured to detect a sensing value within the cooling system and to communicate with the controller.

2. The cooling system of claim 1, wherein the receiving valve includes:
a first valve (434) configured to be selectively open and closed to allow fluid flow from the main fluid circuit to the pump through the secondary fluid circuit; and
a second valve (436) configured to be selectively open and closed to allow fluid flowing from the pump to flow to the receiver on the secondary fluid circuit.

3. The cooling system of claim 2, wherein the returning valve includes:
a third valve (438) configured to be selectively open and closed to allow fluid flow out from the receiver to the pump; and
a fourth valve (440) configured to be selectively open and closed to allow fluid flow from the secondary fluid circuit to the main fluid circuit.

4. The cooling system of any preceding claim, wherein, when the controller determines a fluid leak based on the sensing value, the receiving valve is open and the returning valve is closed.

5. The cooling system of any preceding claim, wherein, when the controller determines no leak based on the sensing value, the receiving valve is closed and the returning valve is open, and optionally wherein, when the controller determines that an amount of fluid in the main fluid circuit is less than a target amount based on the sensing value, the receiving valve is closed and the returning valve is open.

6. The cooling system of any preceding claim, wherein the secondary fluid circuit further includes a scale (440) arranged below the receiver, the scale configured to measure a fluid weight inside the receiver.

7. The cooling system of any preceding claim, wherein the main fluid circuit is configured to connect an indoor unit disposed inside a building and an outdoor unit disposed outside the building, and optionally wherein the outdoor unit includes a condenser (404) and a condenser fan (414), and further optionally wherein the outdoor unit further includes a fluid pump (324), a check valve (408), and a solenoid valve.

8. The cooling system of claim 7, wherein the indoor unit includes an evaporator, an evaporator fan, a compressor, and an expansion device.

9. The cooling system of any preceding claim, wherein the sensor includes at least one of a temperature sensor, a pressure sensor, or a humidity sensor.

10. A method (600) of controlling fluid flow of a cooling system, the method comprising steps of:
detecting, by a sensor, a sensing value;
determining (602), by a controller, whether there is a fluid leak based on the sensing value;
upon determining there is no leak, operating (606) the cooling system in a steady state;
measuring (608), by the sensor, a subcooling value;
determining (612) whether the subcooling value is within a threshold;
upon determining the subcooling value is outside the threshold, controlling a receiving valve to open a returning valve to close to direct fluid flowing from a condenser to a receiver;
waiting (622) for a predetermined period of time; and
repeating the steps.

11. The method of claim 10, further comprising, upon determining that there is leak in the step of determining whether there is fluid leak, controlling the receiving valve to open and the returning valve to close to direct fluid to the receiver.

12. The method of claim 10 or 11, further comprising, upon determining that the subcooling value is within the threshold, closing the receiving valve and opening the returning valve to flow fluid to a main fluid circuit from the receiver.

13. The method of any of claims 10 to 12, further comprising, upon determining that the cooling system is not in the steady state, performing the method from the step of determining whether there is fluid leak.

14. The method of any of claims 10 to 13, wherein the determining whether the subcooling value is within a threshold comprises determining whether the subcooling value greater than or less than the threshold and optionally further comprising, upon determining that the subcooling value is greater than the threshold, closing the receiving valve and opening the returning valve, and/or further comprising, upon determining that the subcooling value is less than the threshold, opening the receiving valve and closing the returning valve.

15. The method of any of claims 10 to 14, further comprising, after determining there is no leak but the cooling system is not operated in the steady state, performing the step of determining whether there is fluid leak based on the sensing value and repeating the steps.
